# EUROPEAN PATENT SPECIFICATION

(11) **EP 4 423 517 B1**
(45) Date of publication and mention of the grant of the patent: **12.08.2026**
(21) Application number: 22801779.4
(22) Date of filing: 13.10.2022
(51) Int. Cl.: G01R 31/389

(54) **CONTROL METHOD AND DEVICE FOR IMPEDANCE SPECTRUM MEASUREMENT OF BATTERY**
STEUERUNGSVERFAHREN UND -VORRICHTUNG ZUR IMPEDANZSPEKTRUMSMESSUNG EINER BATTERIE
PROCÉDÉ ET DISPOSITIF DE COMMANDE POUR LA MESURE DE SPECTRE D'IMPÉDANCE D'UNE BATTERIE

(30) Priority: 25.10.2021 CN 202111243951
(43) Date of publication of application: 04.09.2024
(73) Proprietor: Robert Bosch GmbH, 70442 Stuttgart (DE)
(72) Inventor: ZHOU, Guozhen, Shanghai 200335 (CN); GAO, Peng, Shanghai, 200335 (CN); YU, Liang, Shanghai, 200335 (CN); ZANG, Xiaoyun, Shanghai, 200335 (CN); LIU, Xudan, Shanghai, 200335 (CN); TAO, Junbing, Shanghai, 200335 (CN)
(86) International application number: PCT/EP2022/078527
(87) International publication number: WO 2023/072611

(56) References cited:
- SCHAEF CHRISTOPHER ET AL: "A Hybrid Switched-Capacitor Battery Management IC With Embedded Diagnostics for Series-Stacked Li-Ion Arrays", IEEE JOURNAL OF SOLID-STATE CIRCUITS, IEEE, USA, vol. 52, no. 12, 1 December 2017 (2017-12-01), pages 3142 - 3154, XP011673283, ISSN: 0018-9200, [retrieved on 20171122], DOI: 10.1109/JSSC.2017.2734902
- FERRERO R ET AL: "Low-Cost Battery Monitoring by Converter-Based Electrochemical Impedance Spectroscopy", 2017 IEEE INTERNATIONAL WORKSHOP ON APPLIED MEASUREMENTS FOR POWER SYSTEMS (AMPS), IEEE, 20 September 2017 (2017-09-20), pages 1 - 6, XP033233430, DOI: 10.1109/AMPS.2017.8078334
- VARNOSFADERANI MINA ABEDI ET AL: "Online impedance spectroscopy estimation of a dc-dc converter connected battery using a switched capacitor-based balancing circuit", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, vol. 2019, no. 7, 1 July 2019 (2019-07-01), pages 4681 - 4685, XP006086986, DOI: 10.1049/JOE.2018.8069
- DOTELLI GIOVANNI ET AL: "PEM Fuel Cell Drying and Flooding Diagnosis With Signals Injected by a Power Converter", IEEE TRANSACTIONS ON INSTRUMENTATION AND MEASUREMENT, IEEE, USA, vol. 64, no. 8, 1 August 2015 (2015-08-01), pages 2064 - 2071, XP011662860, ISSN: 0018-9456, [retrieved on 20150710], DOI: 10.1109/TIM.2015.2406051

## Description

### Technical field

The present invention relates to the field of batteries, and more particularly to a control method and device for impedance spectrum measurement of a battery, a vehicle electronic control unit, a computer-readable storage medium, a computer program product, a system for impedance spectrum measurement of a battery, and a vehicle.

### Background art

In electrochemical impedance spectrum measurement, variation characteristics of an impedance (parameters such as an amplitude value of the impedance or a phase angle of the impedance) of an electrochemical system as a function of frequency are calculated by applying an alternating current disturbance or an alternating voltage disturbance to the electrochemical system and measuring a ratio of an alternating voltage signal to an alternating current signal.

With continuous development of fuel cells, more and more attention has been paid to electrochemical impedance spectrum measurement of the fuel cells. By measuring the electrochemical impedance spectrum of the fuel cells, many details about working states of the fuel cells can be reflected.

Currently, impedance spectrum characteristics of fuel cells can be measured in the laboratory, but such a measurement method in the laboratory requires the preparation of particular measurement devices and the construction of a particular test platform, which is costly and cannot reflect on-line impedance characteristics of the fuel cells.

Additionally, impedance spectrum measurement of a battery can be implemented by controlling a power electronic device at an output end of the battery to inject disturbances into the battery. However, the highest frequency at which measurement can be performed in this solution is very limited. Moreover, when a system current is small (that is, in a low-current condition), a disturbance current may enable a current output by the battery to the power electronic device to be negative, that is, a current reversal phenomenon occurs, which is often unbearable by the battery. **Non-patent** Literature "A Hybrid Switched-Capacitor Battery Managemenr IC with Embedded Diagnostics for Series-Stacked Li-ion Arrays", by Schaef et al, published by IEEE, provides a small form factor dc-dc converter that can be used in a ladder architecture to provide state-of-charge equalization for large-scale lithium-ion arrays. The DC-DC converter is further used for injecting frequency components into the battery to do electrochemical impedance spectroscopy. The converter operates in a first, critical conduction mode, where power switches are controlled to turn on at the instant the sensed inductor current reaches zero. The converter may also operate in a second, continuous conduction mode.

### Summary of the invention

The present invention is set out by the appended claims.
According to an aspect of the present invention, a control method for impedance spectrum measurement of a battery is provided, as defined by independent claim 1. The battery outputs a power via a DC-DC converter. The control method includes: sending a first signal, where the first signal indicates a conduction mode of the DC-DC converter to be set, and the conduction mode includes a discontinuous conduction mode or a critical conduction mode; receiving a current measurement value and a voltage measurement value at an output end of the battery; and calculating an impedance spectrum of the battery based on the received current measurement value and the received voltage measurement value.

As an alternative or addition to the above solution, in the control method according to an embodiment of the present invention, the conduction mode further includes a continuous conduction mode. If at least one of the battery, the DC-DC converter, and a load of the battery meets a predetermined criterion, the first signal indicates the DC-DC converter to be set to the discontinuous conduction mode or the critical conduction mode, otherwise, the first signal indicates the DC-DC converter to be set to the continuous conduction mode.

As an alternative or addition to the above solution, the control method according to an embodiment of the present invention further includes: fusing the impedance spectra calculated in different conduction modes.

As an alternative or addition to the above solution, in the control method according to an embodiment of the present invention, the predetermined criterion includes: a current of the load of the battery being less than a predetermined threshold; and/or the battery being in a purge phase.

As an alternative or addition to the above solution, in the control method according to an embodiment of the present invention, when the DC-DC converter is set to the critical conduction mode, the control method further includes: sending a second signal, where the second signal indicates the load of the battery to be changed, so that a switching frequency of the DC-DC converter changes; receiving the current measurement values and the voltage measurement values at the output end of the battery at different switching frequencies; and calculating the impedance spectra of the battery at the different switching frequencies based on the received current measurement values and the received voltage measurement values at the different switching frequencies.

As an alternative or addition to the above solution, the control method according to an embodiment of the present invention further includes: fusing the calculated impedance spectra at the different switching frequencies.

According to another aspect of the present invention, a control device for impedance spectrum measurement of a battery is provided, as defined by independent claim 5. The control device includes a memory, a processor, and a computer program stored on the memory and executable on the processor. The computer program, when executed by the processor, implements the steps in the above control method for impedance spectrum measurement of a battery.

According to another aspect of the present invention, a vehicle electronic control unit is provided. The vehicle electronic control unit includes the above control device for impedance spectrum measurement of a battery.

According to another aspect of the present invention, a computer-readable storage medium is provided. The computer-readable storage medium has a computer program stored thereon. The computer program, when executed by a processor, implements the steps in the above control method for impedance spectrum measurement of a battery.

According to another aspect of the present invention, a computer program product including a computer program is provided. The computer program, when executed by a processor, implements the steps in the above control method for impedance spectrum measurement of a battery.

According to another aspect of the present invention, a system for impedance spectrum measurement of a battery is provided, as defined by independent claim 11. The system for impedance spectrum measurement includes: a DC-DC conversion device configured to convert an output power of the battery, and transmit the converted power to a load, where a conduction mode of the DC-DC conversion device includes a discontinuous conduction mode or a critical conduction mode; a measurement device configured to measure an output current value and an output voltage value of the battery; and a calculation device for calculating an impedance spectrum of the battery based on the measured output current value and the measured output voltage value.

In the system according to the present invention, the conduction mode of the DC-DC conversion device further includes a continuous conduction mode. The system for impedance spectrum measurement further includes a switching device configured to: if at least one of the battery, the DC-DC conversion device, and the load meets a predetermined criterion, switch the DC-DC conversion device to the discontinuous conduction mode or the critical conduction mode, otherwise, switch the DC-DC conversion device to the continuous conduction mode.

As an alternative or addition to the above solution, in the system according to an embodiment of the present invention, the calculation device is further configured to fuse the impedance spectra calculated in different conduction modes.

In the system for impedance spectrum measurement according to the present invention, the predetermined criterion includes: a current of the load being less than a predetermined threshold; and/or the battery being in a purge phase.

As an alternative or addition to the above solution, the system according to an embodiment of the present invention further includes a sending device. The sending device is configured to send a second signal when the DC-DC conversion device is set to the critical conduction mode, where the second signal indicates the load to be changed, so that a switching frequency of the DC-DC conversion device changes. The measurement device is further configured to measure the output current values and the output voltage values of the battery at different switching frequencies. The calculation device is further configured to calculate the impedance spectra of the battery at the different switching frequencies based on the measured output current values and the measured output voltage values.

As an alternative or addition to the above solution, in the system according to an embodiment of the present invention, the calculation device is further configured to fuse the calculated impedance spectra at the different switching frequencies.

As an alternative or addition to the above solution, the system according to an embodiment of the present invention further includes the battery and/or the load.

According to a further aspect of the present invention, a vehicle is provided. The vehicle is equipped with the above system for impedance spectrum measurement of a battery.

In the control solution for impedance spectrum measurement of a battery according to the embodiments of the present invention, it is possible to use an inherent ripple of the DC-DC converter to measure the impedance spectrum of the battery in a low-current condition by setting the conduction mode of the DC-DC converter, thereby avoiding a problem of current reversal from the DC-DC converter to the battery in a measurement process. The control solution neither needs to add an additional harmonic power source to the battery or the DC-DC converter, nor needs to additionally control the DC-DC converter to generate harmonic disturbances. The control solution is simple to operate and easy to implement, and electrochemical impedance values of the battery at high frequencies can be measured.

Further, in the control solution for impedance spectrum measurement of a battery according to the embodiments of the present invention, the conduction mode of the DC-DC converter can be flexibly switched based on actual working conditions of the battery, the DC-DC converter, and the load, to reduce disturbances caused by the measurement to the system as much as possible on the premise of avoiding current reversal. Still further, in the control solution for impedance spectrum measurement of a battery according to the embodiments of the present invention, a range of measurement frequencies can be changed by changing the load in the critical conduction mode, to obtain electrochemical impedance information of the battery in more frequency ranges.

### Brief description of the drawings

The above and other objects and advantages of the present invention will be more complete and clearer from the following detailed description in conjunction with the accompanying drawings, where the same or similar elements are denoted by the same reference numerals.
FIG. 1 is a schematic diagram of a membrane electrode component 1000 of a single fuel cell according to an embodiment;
FIG. 2 is a schematic diagram of an equivalent circuit 2000 of the membrane electrode component 1000 of the fuel cell shown in FIG. 1;
FIG. 3 shows, in the form of a Nyquist plot, an impedance spectrum 3000 of the equivalent circuit 2000 in FIG. 2 in a certain state;
FIG. 4 shows a working environment of a battery for which an impedance spectrum needs to be measured;
FIG. 5 is a flowchart of a control method 5000 for impedance spectrum measurement of a battery according to an embodiment of the present invention;
FIG. 6 shows a current value at an output end of a battery in a control method for impedance spectrum measurement of a battery according to an embodiment of the present invention;
FIG. 7 is a block diagram of a control device 7000 for impedance spectrum measurement of a battery according to an embodiment of the present invention; and
FIG. 8 is a schematic diagram of a system 8000 for impedance spectrum measurement of a battery according to an embodiment of the present invention.

### Detailed description of embodiments

To make the objects, technical solutions, and advantages of the present invention clearer, the technical solutions for forming motor windings according to various exemplary embodiments of the present invention will be described in detail below with reference to the accompanying drawings. It may be understood that the specific embodiments described herein are merely used to explain the present invention, but not to limit the present invention.

It should be noted that, in the context of the present invention, the terms such as "first" and "second" are used to distinguish similar objects, and are not intended to describe the order in terms of time, space, size, etc. Furthermore, the terms "including/comprising", "having", and similar expressions are intended to mean a non-exclusive inclusion, unless otherwise specifically stated.

In the context of the present invention, the term "vehicle" or other similar terms include general motor vehicles, such as passenger vehicles (including sport utility vehicles, buses, trucks, etc.), various commercial vehicles, etc., and include hybrid vehicles, electric vehicles, plug-in hybrid electric vehicles, etc. A hybrid vehicle is a vehicle with two or more power sources, such as a vehicle powered by a gasoline engine and an electric motor.

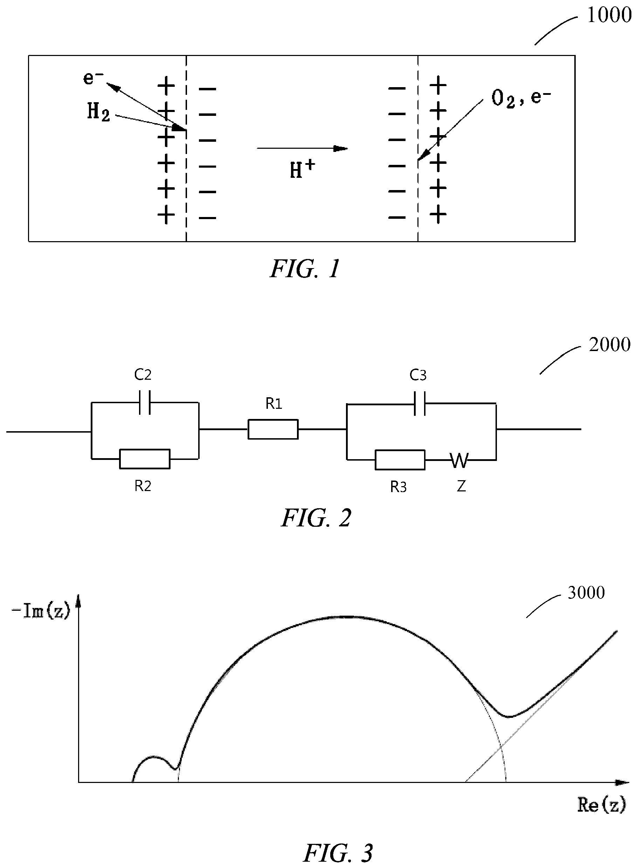

FIG. 1 is a schematic diagram of a membrane electrode component 1000 of a single fuel cell according to an embodiment. It can be seen from FIG. 1 that, the fuel cell has a multi-layer structure and has certain inherent impedance characteristics (such as an inherent resistance and an inherent capacitance). FIG. 2 shows an equivalent circuit 2000 of the fuel cell shown in FIG. 1. In the figure, R₁ represents a membrane resistance, R₂ represents an anode resistance, C₂ represents an anode capacitance, R₃ represents a cathode resistance, C₃ represents a cathode capacitance, and Z represents a gas transfer hindering equivalent impedance. Those skilled in the art can readily understand that the above parameters in the equivalent circuit may vary with a working state, a health state, a frequency, etc. of the fuel cell. As an example, FIG. 3 shows, in the form of a Nyquist plot, variation characteristics of an impedance of the equivalent circuit in FIG. 2 as a function of frequency in a certain state, that is, an impedance spectrum 3000.

There is a measurement method for measuring an impedance spectrum of a battery by using an inherent ripple of a DC-DC converter at an output end of the battery as a disturbance current. In such a measurement method, the DC-DC converter is usually set to a continuous conduction mode. This is because the DC-DC converter has a smaller harmonic content and a lower harmonic amplitude value in the continuous conduction mode.

However, it has found that there are some drawbacks in such a measurement method. For example, when the system is in a low-current condition, it is difficult to implement the above measurement method. This is because, when a direct current of the system is small, an alternating disturbance caused by the inherent ripple of the DC-DC converter working in the continuous conduction mode may enable a total system current to be negative, that is, the current will reversely flow from the DC-DC converter into the fuel cell. This is often unbearable by the fuel cell. For this reason, the present invention proposes an improved solution for impedance spectrum measurement of a battery.

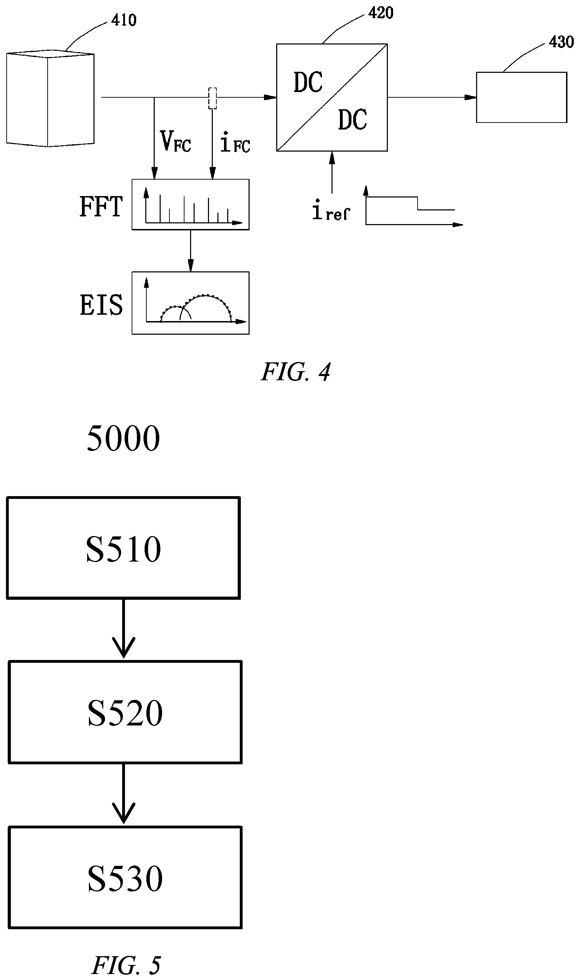

FIG. 4 shows a working environment of a battery for which an impedance spectrum needs to be measured. As shown in FIG. 4, an output power of a battery 410 is transferred to a load 430 via a DC-DC converter 420. The DC-DC converter 420 converts a direct-current power output by the battery 410 into an alternating-current power, and then converts the alternating-current power into a direct-current power according to needs of the load 430. For example, the DC-DC converter 420 converts the power received from the battery 410 based on an output current reference value i_{ref} (as shown in FIG. 4).

FIG. 5 is a flowchart of a control method 5000 for impedance spectrum measurement of a battery according to an embodiment of the present invention. Specific steps of using the control method 5000 to measure an electrochemical impedance spectrum of the battery 410 will be described in detail below with reference to FIGs. 4 and 5.

In step S510, a first signal is sent. The first signal indicates a conduction mode of the DC-DC converter 420 to be set. The conduction mode may be a discontinuous conduction mode or a critical conduction mode.

In step S520, a voltage measurement value V_{FC} and a current measurement value i_{FC} at an output end of the battery 410 set to the discontinuous conduction mode or the critical conduction mode in step S510 are received. The voltage measurement value V_{FC} and the current measurement value i_{FC} are obtained, for example, by a measurement apparatus such as a current transformer or a voltage transformer provided at the output end of the battery 410.

In step S530, an impedance spectrum of the battery is calculated based on the current measurement value i_{FC} and the voltage measurement value V_{FC} received in step S520. Specifically, measured current and voltage values in a time domain may be converted into current and voltage values in a frequency domain by means of a time-frequency transform (such as a Fourier transform (FT), a fast Fourier transform (FFT), or a Z-transform), and impedance values of the battery at different frequencies are then calculated respectively to form an electrochemical impedance spectrum (EIS) measurement result of the battery.

Therefore, the control method 5000 for impedance spectrum measurement of a battery implements impedance spectrum measurement of the battery by using an inherent ripple of the DC-DC converter in a low-current condition, without being limited by current reversal. This is because the current value output by the battery to the DC-DC converter in the discontinuous conduction mode and the critical conduction mode is always greater than zero. Therefore, using the inherent ripple of the DC-DC converter working in the two conduction modes as a disturbance current to the impedance spectrum measurement of the battery does not cause a problem of current reversal from the DC-DC converter to the battery.

The control method 5000 for impedance spectrum measurement of a battery can be flexibly applied to various scenarios, especially on-line measurement scenarios, without adding any additional measurement device or controlling the DC-DC converter to generate any additional voltage and current. This makes the control method simple to operate, easy to implement, and low in investment costs. Compared with the solution of additionally controlling the DC-DC converter to generate an additional disturbance current to measure an impedance of the battery, the control method 5000 can measure an impedance value at a higher frequency.

Optionally, the conduction mode indicated by the first signal in step S510 further includes a continuous conduction mode. If at least one of the battery 410, the DC-DC converter 420, and the load 430 meets a predetermined criterion, the first signal indicates the DC-DC converter 420 to be set to the discontinuous conduction mode or the critical conduction mode. If none of the battery 410, the DC-DC converter 420, and the load 430 meets the predetermined criterion, the first signal indicates the DC-DC converter 420 to be set to the continuous conduction mode.

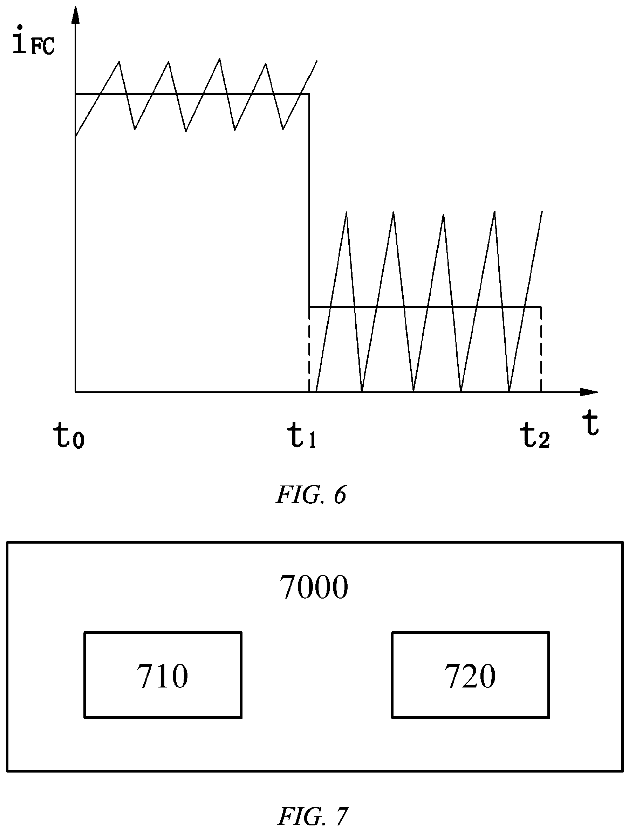

As an example, the predetermined criterion may be the load 430 being in a low-current condition, for example, a current of the load 430 being less than a predetermined current threshold. In this case, an example of a waveform of the current measurement value i_{FC} at the output end of the battery 410 is as shown in FIG. 6. At moments t₁ to t₂, when the current value i_{FC} is relatively small (specifically, less than the predetermined current threshold), the first signal indicates the DC-DC converter 420 to be set to the critical conduction mode. In contrast, at moments t₀ to t₁, when the current value i_{FC} is relatively large (specifically, not less than the predetermined current threshold), the first signal indicates the DC-DC converter 420 to be set to the continuous conduction mode.

It can be seen from FIG. 6 that, when the DC-DC converter is in the continuous conduction mode (that is, at the moments t₀ to t₁), a ripple amplitude value of the current i_{FC} is relatively small, and therefore, losses and disturbances generated by the measurement are relatively small; and when the DC-DC converter is in the critical conduction mode (that is, at the moments t₁ to t₂), although the ripple amplitude value of the current i_{FC} is relatively large, the current i_{FC} is always kept at a positive value, and therefore, a problem of current reversal to the battery does not occur.

Herein, the current threshold may be 0.2 A, 0.5 A, 1 A, or any other current values that can indicate that the system is in a low-current condition.

As another example, the predetermined criterion may be alternatively the entire system being in any other suitable condition, for example, the battery 410 being in a purge phase.

Optionally, the impedance spectra of the battery 410 calculated in different conduction modes are fused. For example, when the impedance spectra of the battery calculated in the different conduction modes do not overlap in terms of frequency, these impedance spectra are directly combined into one impedance spectrum. When the impedance spectra of the battery calculated in the different conduction modes overlap in terms of frequency, screening, a weighted recombination, and other operations can be performed on impedances at an overlapping frequency. Therefore, a higher-precision impedance spectrum measurement result of the battery can be obtained by fusing a plurality of impedance spectra.

Therefore, in the control method 5000 for impedance spectrum measurement of a battery, the conduction mode of the DC-DC converter can be flexibly switched according to actual working conditions of the system, to select an appropriate conduction mode to implement impedance spectrum measurement of the battery. For example, as shown in FIG. 6, the conduction mode of the DC-DC converter is flexibly switched based on a value of an output current of the battery, so that the control method 5000 can not only avoid current reversal to the battery, but can also minimize disturbances and losses generated in the measurement process.

As an example, when the first signal in step S510 indicates the conduction mode of the DC-DC converter 420 to be set to the critical conduction mode, the control method 5000 for impedance spectrum measurement of a battery may further include the following steps.

In step S540 (not shown in the figure), a second signal is sent. The second signal indicates the load 430 to be changed, so that a switching frequency of the DC-DC converter 420 changes.

In the context of the present invention, "changing the load" is intended to mean changing various parameters of the load 430, for example, a power, a voltage, a current, and any other parameters that can change the switching frequency of the DC-DC converter 420. In the critical conduction mode, since the switching frequency of the DC-DC converter 420 may vary with the load 430, an inherent ripple frequency of the DC-DC converter 420 may also vary accordingly, that is, measurement frequency of the battery 410 may vary accordingly.

In step S550 (not shown in the figure), the voltage measurement values V_{FC} and the current measurement values i_{FC} at the output end of the battery at different switching frequencies are received. In addition, in step S560 (not shown in the figure), the impedance spectra of the battery 410 at the different switching frequencies are respectively calculated based on the received voltage measurement values V_{FC} and the received current measurement values i_{FC} at the different switching frequencies. Similar to the above, the impedance spectra of the battery at the different switching frequencies may be fused.

Therefore, when the DC-DC converter is in the critical conduction mode, the switching frequency of the DC-DC converter may be changed by changing the load, thereby changing the measurement frequency of the battery, so that more abundant and accurate impedance spectrum information can be obtained by the control method 5000 for impedance spectrum measurement of a battery.

FIG. 7 is a block diagram of a control device 7000 for impedance spectrum measurement of a battery according to an embodiment of the present invention. The control device 7000 includes a memory 710 and a processor 720. Although not shown in FIG. 7, the control device 7000 further includes a computer program stored on the memory 710 and executable on the processor 720, to implement the steps of the control method for impedance spectrum measurement of a battery in the foregoing embodiments.

The memory 710 may be a random access memory (RAM), a read-only memory (ROM), an electrically programmable read-only memory (EPROM), an electrically erasable programmable read-only memory (EEPROM) or an optical disk storage device, a magnetic disk storage device, or any other media capable of carrying or storing desired program code in the form of machine-executable instructions or data structures and capable of being accessed by the processor 720. The processor 720 may be any suitable dedicated or general-purpose processor such as a field-programmable gate array (FPGA), an application-specific integrated circuit (ASIC), or a digital signal processor (DSP).

Those skilled in the art can readily understand that the above control device 7000 for impedance spectrum measurement of a battery can be incorporated into a vehicle. For example, the battery under test may be a vehicle-mounted battery, and the DC-DC converter is a DC-DC converter that converts a high-voltage direct-current power of the vehicle-mounted battery into a low-voltage direct-current power required by a vehicle load. The control device 7000 may be an independent control device used for impedance spectrum measurement of a battery, or may be integrated into another control device such as an electronic control unit (ECU) or a domain control unit (DCU).

Additionally, those skilled in the art readily understand that the control method for impedance spectrum measurement of a battery provided in one or more of the embodiments of the present invention may be implemented by a computer program. For example, when a computer storage medium (such as a USB flash drive) storing the computer program is connected to a computer, the control method in one or more embodiments of the present invention can be performed by executing the computer program.

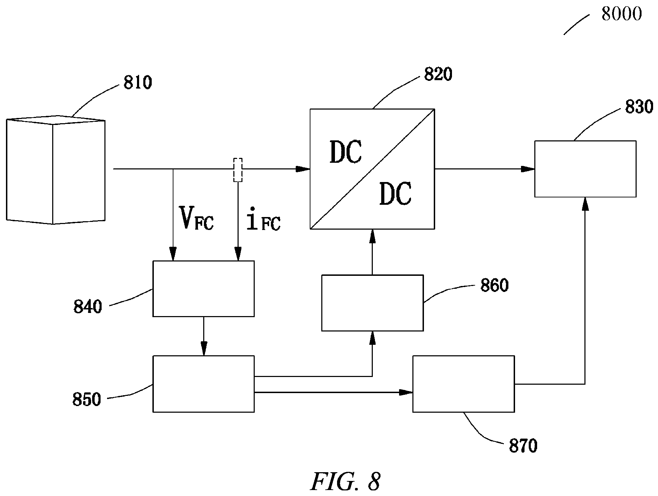

FIG. 8 is a schematic diagram of a system 8000 for impedance spectrum measurement of a battery according to an embodiment of the present invention. The system 8000 for impedance spectrum measurement of a battery includes a DC-DC conversion device 820, a measurement device 840, and a calculation device 850. In addition, the system 8000 for impedance spectrum measurement of a battery may further include a battery under test 810, a load 830, etc.

The DC-DC conversion device 820 is configured to convert an output power of the battery 810, and transmit the converted power to the load 830. A conduction mode of the DC-DC conversion device 820 includes a discontinuous conduction mode, a critical conduction mode, etc. The measurement device 840 is configured to measure an output current value i_{FC} and an output voltage value V_{FC} of the battery 810, and send the measured current value i_{FC} and the measured voltage value V_{FC} to the calculation device 850. The measurement device 840 includes any measurement apparatus capable of measuring a current value and a voltage value at an output port of the battery 810, such as a voltage transformer or a current transformer. The calculation device 850 is configured to calculate an impedance spectrum of the battery 810 based on the measured output current value i_{FC} and the measured voltage value V_{FC}. For example, measured output current and voltage values in a time domain may be converted into current and voltage values in a frequency domain by means of a time-frequency transform (such as a Fourier transform (FT), a fast Fourier transform (FFT), or a Z-transform), and impedance values of the battery at different frequencies are then calculated respectively to form an electrochemical impedance spectrum measurement result of the battery 810.

When the DC-DC conversion device 820 in the system 8000 is set to the discontinuous conduction mode or the critical conduction mode, a current of the DC-DC conversion device 820 is always positive. Therefore, a current output by the battery to the DC-DC conversion device 820 does not become negative even in a low-current condition. In this way, the system 8000 for impedance spectrum measurement of a battery can implement impedance spectrum measurement of the battery using an inherent ripple of the DC-DC conversion device in a low-current condition.

Optionally, the system 8000 further includes a switching device 860, and the conduction mode of the DC-DC conversion device 820 further includes a continuous conduction mode. The switching device 860 is configured to switch the DC-DC conversion device 820 to the discontinuous conduction mode or the critical conduction mode when one or more of the battery 810, the DC-DC conversion device 820, and the load 830 meet a predetermined criterion, and switch the DC-DC conversion device 820 to the continuous conduction mode when the criterion is not met. The calculation device 850 may be further configured to fuse the impedance spectra of the battery in the different conduction modes.

The predetermined criterion may be, for example, a current of the load 830 being less than a predetermined current threshold. For example, the current of the load 830 is less than the predetermined current threshold. Herein, the current threshold may be 0.2 A, 0.5 A, 1 A, or any other current values that can indicate that the system is in a low-current condition. In addition, the predetermined criterion may be alternatively the entire system being in any other suitable condition, for example, the battery 810 being in a purge phase.

Optionally, the system 8000 further includes a sending device 870. The sending device 870 is configured to send a second signal when the DC-DC conversion device 820 is in the critical conduction mode. The second signal indicates the load to be changed, so that a switching frequency of the DC-DC conversion device 820 changes. As mentioned above, "changing the load" is intended to mean changing parameters of the load 830, for example, a power, a voltage, a current, and any other parameters of the load 830 that can change the switching frequency of the DC-DC converter 820. In the critical conduction mode, since the switching frequency of the DC-DC converter 820 may vary with the load 830, an inherent ripple frequency of the DC-DC converter 820 may also vary accordingly, that is, measurement frequency of the battery 810 may vary accordingly.

In this regard, the measurement device 840 may be further configured to measure the output current values and the output voltage values of the battery 810 at different switching frequencies. The calculation device 850 may be further configured to calculate the impedance spectra of the battery 810 at the different switching frequencies based on the measured output current values and the measured output voltage values. Further, the calculation device 850 may be further configured to fuse the impedance spectra at the different switching frequencies.

Those skilled in the art can readily understand that the above system 8000 for impedance spectrum measurement of a battery can be incorporated into a vehicle. For example, the battery under test may be a vehicle-mounted battery, and the DC-DC conversion device may be a DC-DC converter that converts a high-voltage direct-current power of the vehicle-mounted battery into a low-voltage direct-current power required by a vehicle load. The system 8000 can implement an on-line test of an electrochemical impedance spectrum of the vehicle-mounted battery in a low-current condition by switching the conduction mode of the DC-DC converter configured between the battery and the load.

It should be understood that some of the block diagrams shown in the accompanying drawings of the present invention are functional entities and do not necessarily correspond to physically or logically independent entities. These functional entities may be implemented in the form of software, in one or more hardware modules or integrated circuits, or in different networks and/or processor apparatuses and/or micro-controller apparatuses.

It should also be understood that in some alternative embodiments, the functions/steps included in the above method may occur out of the order shown in the flowchart. For example, two functions/steps shown in sequence may be executed substantially simultaneously or even in a reverse order. This specifically depends on the functions/steps involved.

In conclusion, in the control solution for impedance spectrum measurement of a battery according to the embodiments of the present invention, it is possible to use an inherent ripple of the DC-DC converter to measure the impedance spectrum of the battery in a low-current condition by setting the conduction mode of the DC-DC converter, thereby effectively avoiding a problem of current reversal from the DC-DC converter to the battery. In addition, the control solution neither needs to add an additional harmonic power source to the battery or the DC-DC converter, nor needs to additionally control the DC-DC converter to generate harmonic disturbances. The control solution is simple to operate and easy to implement, and electrochemical impedance values of the battery at high frequencies can be measured.

Further, in the control solution for impedance spectrum measurement of a battery according to the embodiments of the present invention, the conduction mode of the DC-DC converter can be flexibly switched based on actual working conditions of the battery, the DC-DC converter, and the load. Still further, in the control solution for impedance spectrum measurement of a battery according to the embodiments of the present invention, a range of measurement frequencies can be changed by changing the load in the critical conduction mode, to obtain electrochemical impedance information of the battery in more frequency ranges.

Although only some of the implementations of the present invention have been described above in this specification, those of ordinary skill in the art should understand that the present invention can be implemented in many other forms without departing from its scope. Therefore, the presented examples and implementations are considered to be schematic rather than restrictive, and without departing from the scope of the present invention that are defined by the appended claims, the present invention may cover various changes.

## Claims

1. A control method (5000) for impedance spectrum measurement of a battery (410), wherein the battery (410) outputs a power via a DC-DC converter (420), wherein the control method comprises:
sending (S510) a first signal, wherein the first signal indicates a conduction mode of the DC-DC converter (420) to be set, and the conduction mode comprises a discontinuous conduction mode or a critical conduction mode;
receiving (S520) a current measurement value and a voltage measurement value at an output end of the battery (410); and
calculating (S530) an impedance spectrum of the battery (410) based on the received current measurement value and the received voltage measurement value.

2. The control method (5000) according to claim 1, wherein the conduction mode further comprises a continuous conduction mode, and
if at least one of the battery (410), the DC-DC converter (420), and a load of the battery (410) meets a predetermined criterion, the first signal indicates the DC-DC converter (420) to be set to the discontinuous conduction mode or the critical conduction mode,
otherwise, the first signal indicates the DC-DC converter (420) to be set to the continuous conduction mode.

3. The control method (5000) according to claim 2, further comprising:
fusing the impedance spectra calculated in different conduction modes.

4. The control method (5000) according to claim 2, wherein the predetermined criterion comprises:
a current of the load of the battery (410) being less than a predetermined threshold; and/or
the battery (410) being in a purge phase.

5. The control method (5000) according to claim 1, wherein when the DC-DC converter (420) is set to the critical conduction mode, the control method (5000) further comprises:
sending a second signal, wherein the second signal indicates the load of the battery (410) to be changed, so that a switching frequency of the DC-DC converter (420) changes;
receiving the current measurement values and the voltage measurement values at the output end of the battery (410) at different switching frequencies; and
calculating the impedance spectra of the battery (410) at the different switching frequencies based on the received current measurement values and the received voltage measurement values at the different switching frequencies.

6. The control method (5000) according to claim 5, further comprising:
fusing the calculated impedance spectra at the different switching frequencies.

7. A control device (7000) for impedance spectrum measurement of a battery (410), the control device (7000) comprising a memory (710), a processor (720), and a computer program stored on the memory and executable on the processor (720), wherein the computer program, when executed by the processor (720), implements the steps in the control method (5000) for impedance spectrum measurement of a battery according to any one of claims 1 to 6.

8. A vehicle electronic control unit comprising the control device (7000) for impedance spectrum measurement of a battery (410) according to claim 7.

9. A computer-readable storage medium having a computer program stored thereon, wherein the computer program, when executed by a processor (720), implements the steps in the control method (5000) for impedance spectrum measurement of a battery according to any one of claims 1 to 6.

10. A computer program product comprising a computer program, wherein the computer program, when executed by a processor (720), implements the steps in the control method (5000) for impedance spectrum measurement of a battery according to any one of claims 1 to 6.

11. A system (8000) for impedance spectrum measurement of a battery (810), comprising:
a DC-DC conversion device (820) configured to convert an output power of the battery, and transmit the converted power to a load (830), wherein the conduction mode of the DC-DC conversion device (820) comprises a discontinuous conduction mode or a critical conduction mode;
a measurement device (840) configured to measure an output current value and an output voltage value of the battery (810);
a calculation device (850) for calculating an impedance spectrum of the battery (810) based on the measured output current value and the measured output voltage value,
the conduction mode of the DC-DC conversion device (820) further comprises a continuous conduction mode; and
the system further comprises a switching device (860) configured to:
if at least one of the battery (810), the DC-DC conversion device (820), and the load (830) meets a predetermined criterion, switch the DC-DC conversion device (820) to the discontinuous conduction mode or the critical conduction mode, otherwise, switch the DC-DC conversion device (820) to the continuous conduction mode,
wherein the predetermined criterion comprises:
a current of the load (830) being less than a predetermined threshold; and/or
the battery (810) being in a purge phase.

12. The system (8000) according to claim 11, wherein
the calculation device (850) is further configured to fuse the impedance spectra calculated in different conduction modes.

13. The system (8000) according to claim 11, further comprising a sending device (870), wherein
the sending device (870) is configured to send a second signal when the DC-DC conversion device (820) is set to the critical conduction mode, wherein the second signal indicates the load to be changed, so that a switching frequency of the DC-DC conversion device (820) changes;
the measurement device (840) is further configured to measure the output current values and the output voltage values of the battery (810) at different switching frequencies; and
the calculation device (850) is further configured to calculate the impedance spectra of the battery (810) at the different switching frequencies based on the measured output current values and the measured output voltage values.

14. The system (8000) according to claim 13, wherein
the calculation device (850) is further configured to fuse the calculated impedance spectra at the different switching frequencies.

15. The system (8000) according to claim 11, further comprising the battery (810) and/or the load (830).

16. A vehicle equipped with the system (8000) for impedance spectrum measurement of a battery according to any one of claims 11 to 15.

## Patentansprüche

1. Steuerungsverfahren (5000) zur Impedanzspektrumsmessung einer Batterie (410), wobei die Batterie (410) eine Leistung über einen DC-DC-Wandler (420) ausgibt, wobei das Steuerungsverfahren Folgendes umfasst:
Senden (S510) eines ersten Signals, wobei das erste Signal einen zu setzenden Leitungsmodus des DC-DC-Wandlers (420) angibt und der Leitungsmodus einen diskontinuierlichen Leitungsmodus oder einen kritischen Leitungsmodus umfasst;
Empfangen (S520) eines Strommesswerts und eines Spannungsmesswerts an einem Ausgangsende der Batterie (410); und
Berechnen (S530) eines Impedanzspektrums der Batterie (410) basierend auf dem empfangenen Strommesswert und dem empfangenen Spannungsmesswert.

2. Steuerungsverfahren (5000) nach Anspruch 1, wobei der Leitungsmodus ferner einen kontinuierlichen Leitungsmodus umfasst, und
wobei, falls die Batterie (410) und/oder der DC-DC-Wandler (420) und/oder eine Last der Batterie (410) ein vorbestimmtes Kriterium erfüllt, das erste Signal angibt, dass der DC-DC-Wandler (420) in den diskontinuierlichen Leitungsmodus oder den kritischen Leitungsmodus versetzt werden soll,
wobei andernfalls das erste Signal angibt, dass der DC-DC-Wandler (420) in den kontinuierlichen Leitungsmodus versetzt werden soll.

3. Steuerungsverfahren (5000) nach Anspruch 2, das ferner Folgendes umfasst:
Fusionieren der in verschiedenen Leitungsmodi berechneten Impedanzspektren.

4. Steuerungsverfahren (5000) nach Anspruch 2, wobei das vorbestimmte Kriterium Folgendes umfasst:
ein Strom der Last der Batterie (410) ist kleiner als eine vorbestimmte Schwelle; und/oder
die Batterie (410) befindet sich in einer Entladungsphase.

5. Steuerungsverfahren (5000) nach Anspruch 1, wobei, wenn der DC-DC-Wandler (420) auf den kritischen Leitungsmodus gesetzt ist, das Steuerungsverfahren (5000) ferner Folgendes umfasst:
Senden eines zweiten Signals, wobei das zweite Signal die zu ändernde Last der Batterie (410) angibt, so dass sich eine Schaltfrequenz des DC-DC-Wandlers (420) ändert;
Empfangen der Strommesswerte und der Spannungsmesswerte am Ausgangsende der Batterie (410) bei unterschiedlichen Schaltfrequenzen; und
Berechnen der Impedanzspektren der Batterie (410) bei den unterschiedlichen Schaltfrequenzen basierend auf den empfangenen Strommesswerten und den empfangenen Spannungsmesswerten bei den unterschiedlichen Schaltfrequenzen.

6. Steuerungsverfahren (5000) nach Anspruch 5, das ferner Folgendes umfasst:
Fusionieren der berechneten Impedanzspektren bei den unterschiedlichen Schaltfrequenzen.

7. Steuerungsvorrichtung (7000) zur Impedanzspektrumsmessung einer Batterie (410), wobei die Steuerungsvorrichtung (7000) einen Speicher (710), einen Prozessor (720) und ein Computerprogramm, das in dem Speicher gespeichert und auf dem Prozessor (720) ausführbar ist, umfasst, wobei das Computerprogramm, wenn es durch den Prozessor (720) ausgeführt wird, die Schritte in dem Steuerungsverfahren (5000) zur Impedanzspektrumsmessung einer Batterie nach einem der Ansprüche 1 bis 6 implementiert.

8. Elektronische Fahrzeugsteuereinheit, die die Steuerungsvorrichtung (7000) zur Impedanzspektrumsmessung einer Batterie (410) nach Anspruch 7 umfasst.

9. Computerlesbares Speichermedium mit einem darauf gespeicherten Computerprogramm, wobei das Computerprogramm, wenn es durch einen Prozessor (720) ausgeführt wird, die Schritte des Steuerungsverfahrens (5000) zur Impedanzspektrumsmessung einer Batterie nach einem der Ansprüche 1 bis 6 implementiert.

10. Computerprogrammprodukt, das ein Computerprogramm umfasst, wobei das Computerprogramm, wenn es durch einen Prozessor (720) ausgeführt wird, die Schritte in dem Steuerungsverfahren (5000) zur Impedanzspektrumsmessung einer Batterie nach einem der Ansprüche 1 bis 6 implementiert.

11. System (8000) zur Impedanzspektrumsmessung einer Batterie (810), das Folgendes umfasst:
eine DC-DC-Umwandlungsvorrichtung (820), die dazu ausgelegt ist, eine Ausgangsleistung der Batterie umzuwandeln und die umgewandelte Leistung an eine Last (830) zu übertragen, wobei der Leitungsmodus der DC-DC-Umwandlungsvorrichtung (820) einen diskontinuierlichen Leitungsmodus oder einen kritischen Leitungsmodus umfasst;
eine Messvorrichtung (840), die dazu ausgelegt ist, einen Ausgangsstromwert und einen Ausgangsspannungswert der Batterie (810) zu messen;
eine Berechnungsvorrichtung (850) zum Berechnen eines Impedanzspektrums der Batterie (810) basierend auf dem gemessenen Ausgangsstromwert und dem gemessenen Ausgangsspannungswert,
wobei der Leitungsmodus der DC-DC-Umwandlungsvorrichtung (820) ferner einen kontinuierlichen Leitungsmodus umfasst; und
wobei das System ferner eine Schaltvorrichtung (860) umfasst, die ausgelegt ist zum:
falls die Batterie (810), die DC-DC-Umwandlungsvorrichtung (820) und/oder die Last (830) ein vorbestimmtes Kriterium erfüllen, Schalten der DC-DC-Umwandlungsvorrichtung (820) in den diskontinuierlichen Leitungsmodus oder den kritischen Leitungsmodus, andernfalls Schalten der DC-DC-Umwandlungsvorrichtung (820) in den kontinuierlichen Leitungsmodus,
wobei das vorbestimmte Kriterium Folgendes umfasst:
ein Strom der Last (830) ist kleiner als eine vorbestimmte Schwelle; und/oder
die Batterie (810) befindet sich in einer Entladungsphase.

12. System (8000) nach Anspruch 11, wobei
die Berechnungsvorrichtung (850) ferner dazu ausgelegt ist, die in verschiedenen Leitungsmodi berechneten Impedanzspektren zu fusionieren.

13. System (8000) nach Anspruch 11, das ferner eine Sendevorrichtung (870) umfasst, wobei
die Sendevorrichtung (870) dazu ausgelegt ist, ein zweites Signal zu senden, wenn die DC-DC-Umwandlungsvorrichtung (820) in den kritischen Leitungsmodus gesetzt ist, wobei das zweite Signal die zu ändernde Last angibt, so dass sich eine Schaltfrequenz der DC-DC-Umwandlungsvorrichtung (820) ändert;
die Messvorrichtung (840) ferner dazu ausgelegt ist, die Ausgangsstromwerte und die Ausgangsspannungswerte der Batterie (810) bei unterschiedlichen Schaltfrequenzen zu messen; und
die Berechnungsvorrichtung (850) ferner dazu ausgelegt ist, die Impedanzspektren der Batterie (810) bei den unterschiedlichen Schaltfrequenzen basierend auf den gemessenen Ausgangsstromwerten und den gemessenen Ausgangsspannungswerten zu berechnen.

14. System (8000) nach Anspruch 13, wobei
die Berechnungsvorrichtung (850) ferner dazu ausgelegt ist, die berechneten Impedanzspektren bei den unterschiedlichen Schaltfrequenzen zu fusionieren.

15. System (8000) nach Anspruch 11, das ferner die Batterie (810) und/oder die Last (830) umfasst.

16. Fahrzeug, das mit dem System (8000) zur Impedanzspektrumsmessung einer Batterie nach einem der Ansprüche 11 bis 15 ausgestattet ist.

## Revendications

1. Procédé de commande (5000) pour la mesure de spectre d'impédance d'une batterie (410), dans lequel la batterie (410) délivre une puissance par l'intermédiaire d'un convertisseur CC-CC (420), dans lequel le procédé de commande comprend :
l'envoi (S510) d'un premier signal, dans lequel le premier signal indique un mode de conduction du convertisseur CC-CC (420) à régler, et le mode de conduction comprend un mode de conduction discontinu ou un mode de conduction critique ;
la réception (S520) d'une valeur de mesure de courant et d'une valeur de mesure de tension au niveau d'une extrémité de sortie de la batterie (410) ; et
le calcul (S530) d'un spectre d'impédance de la batterie (410) sur la base de la valeur de mesure de courant reçue et de la valeur de mesure de tension reçue.

2. Procédé de commande (5000) selon la revendication 1, dans lequel le mode de conduction comprend en outre un mode de conduction continu, et
si au moins l'un de la batterie (410), du convertisseur CC-CC (420), et d'une charge de la batterie (410) satisfait un critère prédéterminé, le premier signal indique que le convertisseur CC-CC (420) doit être réglé sur le mode de conduction discontinu ou le mode de conduction critique,
dans le cas contraire, le premier signal indique que le convertisseur CC-CC (420) doit être réglé sur le mode de conduction continu.

3. Procédé (5000) selon la revendication 2, comprenant en outre :
la fusion des spectres d'impédance calculés dans différents modes de conduction.

4. Procédé de commande (5000) selon la revendication 2, dans lequel le critère prédéterminé comprend :
un courant de la charge de la batterie (410) étant inférieur à un seuil prédéterminé ; et/ou
la batterie (410) étant dans une phase de purge.

5. Procédé de commande (5000) selon la revendication 1, dans lequel lorsque le convertisseur CC-CC (420) est réglé sur le mode de conduction critique, le procédé de commande (5000) comprend en outre :
l'envoi d'un second signal, dans lequel le second signal indique la charge de la batterie (410) à changer, de sorte qu'une fréquence de commutation du convertisseur CC-CC (420) change ;
la réception des valeurs de mesure de courant et des valeurs de mesure de tension au niveau de l'extrémité de sortie de la batterie (410) à des fréquences de commutation différentes ; et
le calcul des spectres d'impédance de la batterie (410) aux différentes fréquences de commutation sur la base des valeurs de mesure de courant reçues et des valeurs de mesure de tension reçues aux différentes fréquences de commutation.

6. Procédé (5000) selon la revendication 5, comprenant en outre :
la fusion des spectres d'impédance calculés aux différentes fréquences de commutation.

7. Dispositif de commande (7000) pour la mesure du spectre d'impédance d'une batterie (410), le dispositif de commande (7000) comprenant une mémoire (710), un processeur (720) et un programme informatique stocké sur la mémoire et exécutable sur le processeur (720), dans lequel le programme informatique, lorsqu'il est exécuté par le processeur (720), met en œuvre les étapes du procédé de commande (5000) pour la mesure du spectre d'impédance d'une batterie selon l'une quelconque des revendications 1 à 6.

8. Unité de commande électronique de véhicule comprenant le dispositif de commande (7000) pour la mesure du spectre d'impédance d'une batterie (410) selon la revendication 7.

9. Support de stockage lisible par ordinateur ayant un programme informatique stocké sur celui-ci, dans lequel le programme informatique, lorsqu'il est exécuté par un processeur (720), met en œuvre les étapes du procédé de commande (5000) pour la mesure du spectre d'impédance d'une batterie selon l'une quelconque des revendications 1 à 6.

10. Produit-programme informatique comprenant un programme informatique, dans lequel le programme informatique, lorsqu'il est exécuté par un processeur (720), met en œuvre les étapes du procédé de commande (5000) pour la mesure du spectre d'impédance d'une batterie selon l'une quelconque des revendications 1 à 6.

11. Système (8000) de mesure du spectre d'impédance d'une batterie (810), comprenant :
un dispositif de conversion CC-CC (820) configuré pour convertir une puissance de sortie de la batterie, et transmettre la puissance convertie à une charge (830), dans lequel le mode de conduction du dispositif de conversion CC-CC (820) comprend un mode de conduction discontinu ou un mode de conduction critique ;
un dispositif de mesure (840) configuré pour mesurer une valeur de courant de sortie et une valeur de tension de sortie de la batterie (810) ;
un dispositif de calcul (850) pour calculer un spectre d'impédance de la batterie (810) sur la base de la valeur de courant de sortie mesurée et de la valeur de tension de sortie mesurée,
le mode de conduction du dispositif de conversion CC-CC (820) comprend en outre un mode de conduction continu ; et
le système comprend en outre un dispositif de commutation (860) configuré pour :
si au moins l'un de la batterie (810), du dispositif de conversion CC/CC (820), et de la charge (830) satisfait un critère prédéterminé, commuter le dispositif de conversion CC/CC (820) en mode de conduction discontinu ou en mode de conduction critique, dans le cas contraire, commuter le dispositif de conversion CC/CC (820) en mode de conduction continu,
dans lequel le critère prédéterminé comprend :
un courant de la charge (830) étant inférieur à un seuil prédéterminé ; et/ou
la batterie (810) étant dans une phase de purge.

12. Système (8000) selon la revendication 11, dans lequel
le dispositif de calcul (850) est en outre configuré pour fusionner les spectres d'impédance calculés dans différents modes de conduction.

13. Système (8000) selon la revendication 11, comprenant en outre un dispositif d'envoi (870), dans lequel
le dispositif d'envoi (870) est configuré pour envoyer un second signal lorsque le dispositif de conversion CC-CC (820) est réglé sur le mode de conduction critique, dans lequel le second signal indique la charge à changer, de sorte qu'une fréquence de commutation du dispositif de conversion CC-CC (820) change ;
le dispositif de mesure (840) est en outre configuré pour mesurer les valeurs de courant de sortie et les valeurs de tension de sortie de la batterie (810) à des fréquences de commutation différentes ; et
le dispositif de calcul (850) est en outre configuré pour calculer les spectres d'impédance de la batterie (810) aux différentes fréquences de commutation sur la base des valeurs de courant de sortie mesurées et des valeurs de tension de sortie mesurées.

14. Système (8000) selon la revendication 13, dans lequel
le dispositif de calcul (850) est en outre configuré pour fusionner les spectres d'impédance calculés aux différentes fréquences de commutation.

15. Système (8000) selon la revendication 11, comprenant en outre la batterie (810) et/ou la charge (830).

16. Véhicule équipé du système (8000) de mesure du spectre d'impédance d'une batterie selon l'une quelconque des revendications 11 à 15.
